# EUROPEAN PATENT APPLICATION

(11) **EP 4 661 377 A1**
(43) Date of publication of application: **10.12.2025**
(21) Application number: 24813827.3
(22) Date of filing: 18.03.2024
(51) Int. Cl.: H04M 1/02

(54) **ELECTRONIC DEVICE**

(30) Priority: 26.05.2023 CN 202310610247
(71) Applicant: Honor Device Co., Ltd., Shenzhen, Guangdong 518040 (CN)
(72) Inventor: LI, Zhandong, Shenzhen, Guangdong 518040 (CN)
(74) Representative: Epping - Hermann - Fischer
(86) International application number: PCT/CN2024/082256
(87) International publication number: WO 2024/244621

(57) **Abstract**

Embodiments of this application provide an electronic device, to resolve a problem of an insufficient layout area for circuit boards. The electronic device includes: a housing structure, including at least a first part and a second part, where a plane in which the first part is located is different from a plane in which the second part is located; and a circuit board assembly, located on a side of the housing structure. The circuit board assembly includes at least two circuit boards. The at least two circuit boards include at least a first circuit board and at least one second circuit board that are stacked. The first circuit board is located on a side that is of the second circuit board and that faces away from the housing structure. A distance from the first part to the first circuit board is greater than a distance from the second part to the first circuit board. The circuit board includes a first surface and a second surface. A position that is of the circuit board assembly and that corresponds to the first part is provided with a functional component, and a quantity of surfaces each provided with a functional component is a first preset value. A position that is of the circuit board assembly and that corresponds to the second part is provided with a functional component, and a quantity of surfaces each provided with a functional component is a second preset value. The first preset value is greater than the second preset value.

## Description

This application claims priority to Chinese Patent Application No. 202310610247.4, filed with the China National Intellectual Property Administration on May 26, 2023 and entitled "ELECTRONIC DEVICE", which is incorporated herein by reference in its entirety.

### TECHNICAL FIELD

This application relates to the field of electronic technologies, and in particular, to an electronic device.

### BACKGROUND

As electronic devices such as a mobile phone and a tablet computer are increasingly enriched in functions and improved in performance, more components are required to be integrated on a circuit board. There is only one circuit board in a conventional electronic device, and more components can be arranged only in a plane direction. However, as a battery life and capacity increase, and the like, a circuit board size decreases, resulting in an insufficient layout area. Therefore, how to dispose more components in a limited space is an urgent problem to be resolved.

### SUMMARY

To resolve the foregoing technical problem, this application provides an electronic device, to resolve a problem of an insufficient layout area.

According to a first aspect, an embodiment of this application provides an electronic device. The electronic device includes: a housing structure, including at least a first part and a second part, where a plane in which the first part is located is different from a plane in which the second part is located; and a circuit board assembly, where in a first direction, the circuit board assembly is located on a side of the housing structure, and the first direction is perpendicular to the plane in which the first part is located. The circuit board assembly includes at least two circuit boards. The at least two circuit boards include at least a first circuit board and at least one second circuit board that are stacked. In the first direction, the first circuit board is located on a side that is of the second circuit board and that faces away from the housing structure, and a distance from the first part to the first circuit board is greater than a distance from the second part to the first circuit board. In the first direction, the circuit board includes two surfaces facing away from each other. The two surfaces include a first surface and a second surface. Each of the first surface and/or the second surface is provided with a functional component. A position that is of the circuit board assembly and that corresponds to the first part is provided with a functional component, and a quantity of surfaces each provided with a functional component is a first preset value. A position that is of the circuit board assembly and that corresponds to the second part is provided with a functional component, and a quantity of surfaces each provided with a functional component is a second preset value. The first preset value is greater than the second preset value.

For example, the first direction is a Z-axis direction in this embodiment.

For example, the plane in which the first part is located is parallel to the plane in which the second part is located.

For example, planes in which the circuit boards are located are parallel to the plane in which the first part is located.

For example, the position that is of the circuit board assembly and that corresponds to the first part is a region in which a projection of the circuit board assembly on a plane formed by an X axis and a Y axis overlaps with a projection of the first part on the plane formed by the X axis and the Y axis.

For example, the position that is of the circuit board assembly and that corresponds to the second part is a region in which the projection of the circuit board assembly on the plane formed by the X axis and the Y axis overlaps with a projection of the second part on the plane formed by the X axis and the Y axis.

Because each circuit board includes only two surfaces, the quantity of surfaces each provided with a functional component is related to which surface of the circuit boards is provided with a functional component, and is further related to a quantity of circuit boards. Because the plane in which the first part is located is different from the plane in which the second part is located, the housing structure has different height limitations on the circuit board assembly. In this embodiment of this application, a height limitation difference is flexibly used to increase a quantity of circuit boards in a space in the Z-axis direction. In addition, because quantities of surfaces each provided with a functional component are different at different positions, or although quantities of circuit boards are the same, because quantities of surfaces each provided with a functional component are different, the circuit board assembly has different heights in the Z-axis direction. In this way, a space of the electronic device in the Z-axis direction is fully used, a component arrangement area is increased, component integration is improved, and a problem of an insufficient layout area is resolved.

According to the first aspect, a quantity of circuit boards at the position that is of the circuit board assembly and that corresponds to the first part is a third preset value, a quantity of circuit boards at the position that is of the circuit board assembly and that corresponds to the second part is a fourth preset value, and the third preset value is greater than or equal to the fourth preset value.

For example, there are three circuit boards at the position that is of the circuit board assembly and that corresponds to the first part of the housing structure, and there are two circuit boards at the position that is of the circuit board assembly and that corresponds to the second part of the housing structure. In this way, a quantity of surfaces of the three circuit boards is six, and a quantity of surfaces of the two circuit boards is four, five of the six surfaces are each provided with a functional component, and three of the four surfaces are each provided with a functional component.

For example, there are two circuit boards at the position that is of the circuit board assembly and that corresponds to the first part of the housing structure, and four surfaces of the two circuit boards are each provided with a functional component; and there are two circuit boards at the position that is of the circuit board assembly and that corresponds to the second part of the housing structure, and three of four surfaces of the two circuit boards are each provided with a functional component.

According to the first aspect or any implementation of the first aspect, the circuit board assembly further includes at least one third circuit board, the first circuit board includes at least a first region and a second region, the second circuit board is located at least in the first region, the first circuit board is successively stacked with the at least one second circuit board at an interval, the third circuit board is located at least in the second region, and the first circuit board is successively stacked with the at least one third circuit board at an interval; the circuit board assembly further includes a support connector, located between two adjacent circuit boards, and configured to support the circuit board and electrically connect the two adjacent circuit boards; and the first region is opposite to the first part, the second region is opposite to the second part, the first region is provided with a functional component, a quantity of surfaces each provided with a functional component is the first preset value, the second region is provided with a functional component, and a quantity of surfaces each provided with a functional component is the second preset value.

Therefore, the quantity of circuit boards is large, and more functional components can be disposed without occupying a size of the electronic device in a horizontal plane.

For example, the second circuit board may be further located in another region in addition to the first region, and the third circuit board may be further located in another region in addition to the second region.

According to the first aspect or any implementation of the first aspect, the electronic device further includes a rear cover, and the housing structure is the rear cover of the electronic device. Certainly, the housing structure is not limited to the rear cover, and may alternatively be another structure.

When the housing structure is the rear cover, a specific structure of the circuit board assembly may be disposed based on a shape of the rear cover, to fully use the space in the Z-axis direction, increase the component arrangement area, improve component integration, and resolve the problem of an insufficient layout area.

According to the first aspect or any implementation of the first aspect, the electronic device further includes a rear cover, and a decorative hole is disposed on the rear cover; the housing structure is a camera decorative member (referred to as a decorative member), the camera decorative member includes a shielding part and a skirt edge, the skirt edge surrounds at least a part of the shielding part, the decorative member is fastened to the battery cover by using the skirt edge, and the shielding part is exposed through the decorative hole; the first part is the shielding part, the second part is the skirt edge, H1>H2>H3, H1 is a distance from the shielding part to the first circuit board, H2 is a distance from the rear cover to the first circuit board, and H3 is a distance from the skirt edge to the first circuit board; the first circuit board includes a first region, a second region, and a third region, the first region is opposite to the shielding part, the second region is opposite to the skirt edge, the third region is opposite to a preset region of the rear cover, and the preset region of the rear cover is a part in which a projection of the rear cover on a plane in which the first circuit board is located overlaps with the third region; and a quantity of surfaces each provided with a functional component in the first region is greater than a quantity of surfaces each provided with a functional component in the second region, and is greater than a quantity of surfaces each provided with a functional component in the third region.

That is, there is a larger space between the plane in which the shielding part is located and the first circuit board, a moderate space between a plane in which the rear cover is located and the first circuit board, and a smaller space between a plane in which the skirt edge is located and the first circuit board, more functional components are disposed and/or a functional component with a larger height is disposed in the region with the larger space, functional components of a moderate quantity are disposed and/or a functional component with a moderate height is disposed in the region with the moderate space, and fewer functional components are disposed and/or a functional component with a smaller height is disposed in the region with the smaller space, thereby fully using the space of the electronic device in the Z-axis direction, and resolving the problem of an insufficient layout area.

According to the first aspect or any implementation of the first aspect, in a second direction, the second region includes a first sub-region and a second sub-region disposed on two sides of the first region, and the second direction is perpendicular to the first direction; the circuit board assembly includes a first circuit board, two second circuit boards, and one third circuit board, the two second circuit boards are stacked at an interval in the first region, a second circuit board adjacent to the first circuit board extends to the second sub-region and the third region, and the third circuit board is disposed at least in the second sub-region; the first surface is located on a side that is of the second surface and that faces away from the housing structure; and two surfaces of the first circuit board are each provided with a functional component, two surfaces of the second circuit board adjacent to the first circuit board are each provided with a functional component, a second surface of the second circuit board away from the first circuit board is provided with a functional component, and a second surface of the third circuit board is provided with a functional component.

Therefore, the first region, the second sub-region, and the third region share a same second circuit board, to reduce the quantity of circuit boards, thereby simplifying a process step.

For example, the second direction is a Y-axis direction in this embodiment.

According to the first aspect or any implementation of the first aspect, in the first direction, a height of a first functional component is less than a height of a second functional component, the first functional component is a highest functional component disposed on a second surface of the first circuit board in the first sub-region, and the second functional component is a highest functional component disposed on the second surface of the first circuit board in another region. Therefore, a thickness of the support connector in the first sub-region is reduced, thereby ensuring a small overall thickness of the circuit board assembly in the first sub-region.

According to the first aspect or any implementation of the first aspect, in the first direction, a height of the functional component on the second surface of the third circuit board is greater than a height of a functional component on a surface of another circuit board. Therefore, functional components with larger heights are disposed on the second surface of the third circuit board together, thereby avoiding waste of a Z-axis space that is caused by different heights of functional components disposed in other regions.

According to the first aspect or any implementation of the first aspect, the functional component on the second surface of the third circuit board includes a component with a larger height such as a board-to-board connector.

According to the first aspect or any implementation of the first aspect, a second surface of the first circuit board, a first surface of the second circuit board adjacent to the first circuit board, and the support connector enclose a first accommodating space, a second surface of the second circuit board adjacent to the first circuit board, a first surface of the second circuit board away from the first circuit board, and the support connector enclose a second accommodating space, and the second surface of the first circuit board, a first surface of the third circuit board, and the support connector enclose a third accommodating space; and functional components on the second surface of the first circuit board that correspond to the first region, the second sub-region, and the third region and a functional component on the first surface of the second circuit board adjacent to the first circuit board are all located in the first accommodating space, a functional component that is on the second surface of the second circuit board adjacent to the first circuit board and that corresponds to the first region is located in the second accommodating space, and a functional component that is on the second surface of the first circuit board and that corresponds to the first sub-region is located in the third accommodating space, thereby protecting the functional components.

According to the first aspect or any implementation of the first aspect, shielding covers are disposed on outer sides of at least some of the following functional components: a functional component on a first surface of the first circuit board, a functional component on a second surface of the second circuit board away from the first circuit board, and a functional component that is on a second surface of the second circuit board adjacent to the first circuit board and that corresponds to the second sub-region, thereby protecting the functional components.

For example, a shielding cover is disposed on an outer side of the functional component on the first surface of the first circuit board, and a shielding cover is disposed on an outer side of the functional component on the second surface of the second circuit board away from the first circuit board, and/or a shielding cover is disposed on an outer side of the functional component that is on the second surface of the second circuit board adjacent to the first circuit board and that corresponds to the second sub-region.

According to the first aspect or any implementation of the first aspect, a light-transmitting hole is disposed on the shielding part, the electronic device further includes a camera module, a projection of the camera module on the plane in which the first part is located overlaps with a projection of the shielding part on the plane in which the first part is located, and the camera module collects a light source through the light-transmitting hole, thereby implementing a shooting function of the electronic device, and improving a shooting effect of the camera module.

According to the first aspect or any implementation of the first aspect, a thickness of the camera module is greater than the distance from the shielding part to the first circuit board; and the first circuit board further includes a fourth region, the fourth region is opposite to the shielding part, the first circuit board is provided with an avoidance hole in the fourth region, and one end of the camera module passes through the avoidance hole. Therefore, normal operation of the camera module is ensured, and the space of the electronic device in the Z-axis direction is fully used, so that the component arrangement area is increased, component integration is improved, and the problem of an insufficient layout area is resolved.

According to the first aspect or any implementation of the first aspect, a difference between the distance from the shielding part to the first circuit board and the thickness of the camera module is within a preset range; and the first circuit board further includes a fourth region, the fourth region is opposite to the shielding part, and the camera module is disposed in the fourth region of the first circuit board, to fasten and support the camera module by using the first circuit board. In this way, a position for disposing the camera module is more flexible, and a region of a support member of the middle frame is released, thereby facilitating disposing another structure on the support member.

According to the first aspect or any implementation of the first aspect, a difference between a distance from the shielding part to the third circuit board and the thickness of the camera module is within a preset range; and the third circuit board extends to be below the camera module, and the camera module is disposed on the third circuit board, to fasten and support the camera module by using the third circuit board. In this way, a position for disposing the camera module is more flexible, and a region of a support member of the middle frame is released, thereby facilitating disposing another structure on the support member.

According to the first aspect or any implementation of the first aspect, when the circuit board assembly further includes the support connector, the support connector includes a frame board. The frame board is a type of PCB, which has a structure the same as or basically the same as a structure of a conventional PCB, and has internal cabling for implementing electrical connection. The frame board may be obtained by dividing an entire PCB. When the frame board is disposed on the circuit board, an area occupied by the frame board on the circuit board is small, thereby implementing area saving to arrange more components.

According to the first aspect or any implementation of the first aspect, when the circuit board assembly further includes the support connector, the support connector is integrally formed with the circuit board. For example, the support connector and the circuit board that are integrally formed may be formed through a manufacturing process of a cavity (local recession) structure of a PCB. In addition, because reflow soldering is not required for the support connector and the circuit board, a quantity of times of reflow may be reduced, thereby preventing the functional component on the circuit board from being affected when the quantity of times of reflow is large.

### BRIEF DESCRIPTION OF DRAWINGS

FIG. 1 is a schematic diagram of a structure of an electronic device according to an embodiment of this application;
FIG. 2 is an exploded view of an electronic device according to an embodiment of this application;
FIG. 3 is a sectional view of the electronic device shown in FIG. 1 in a direction WW';
FIG. 4 is a schematic diagram of a structure of a decorative member according to an embodiment of this application;
FIG. 5 is a top view of a positional relationship between a decorative member and a circuit board assembly according to an embodiment of this application;
FIG. 6 is a side view of a positional relationship between a decorative member, a circuit board assembly, and a battery cover according to an embodiment of this application;
FIG. 7 is a side view of another positional relationship between a decorative member, a circuit board assembly, and a battery cover according to an embodiment of this application;
FIG. 8 is a side view of still another positional relationship between a decorative member, a circuit board assembly, and a battery cover according to an embodiment of this application;
FIG. 9 is a side view of still another positional relationship between a decorative member, a circuit board assembly, and a battery cover according to an embodiment of this application; and
FIG. 10 is a flowchart of a method for preparing a circuit board assembly according to an embodiment of this application.

### DESCRIPTION OF EMBODIMENTS

The technical solutions in the embodiments of this application are clearly and completely described below with reference to the accompanying drawings in the embodiments of this application. Clearly, the described embodiments are some rather than all of the embodiments of this application. All other embodiments obtained by a person of ordinary skill in the art based on the embodiments of this application without creative efforts shall fall within the protection scope of this application.

In the specification, the term "and/or" is merely used to describe an association relationship between associated objects, and indicates that three relationships may exist. For example, A and/or B may indicate the following three cases: Only A exists, both A and B exist, and only B exists.

The terms "first", "second", and the like in the specification and claims of the embodiments of this application are used to distinguish between different objects, and are not used to describe a particular order of the objects. For example, a first target object, a second target object, and the like are used to distinguish between different target objects, and are not used to describe a particular order of the target objects.

In the embodiments of this application, words such as "example" or "for example" are used to represent giving an example, an illustration, or a description. Any embodiment or design solution described as "example" or "for example" in the embodiments of this application should not be explained as being preferred or advantageous over other embodiments or design solutions. Specifically, the words such as "example" or "for example" are used to present related concepts in a specific manner.

In the description of the embodiments of this application, unless otherwise stated, "a plurality of" means two or more. For example, a plurality of processing units refer to two or more processing units, and a plurality of systems refer to two or more systems.

An embodiment of this application provides an electronic device. The electronic device provided in this embodiment of this application may be a mobile phone, a tablet computer, a notebook computer, a personal digital assistant (personal digital assistant, PDA for short), a vehicle-mounted computer, a television, a smart wearable device (for example, a smartwatch or a smart bracelet), a smart home device, or the like. A specific form of the electronic device is not particularly limited in this embodiment of this application. For ease of description, an example in which the electronic device is a mobile phone is used below for description.

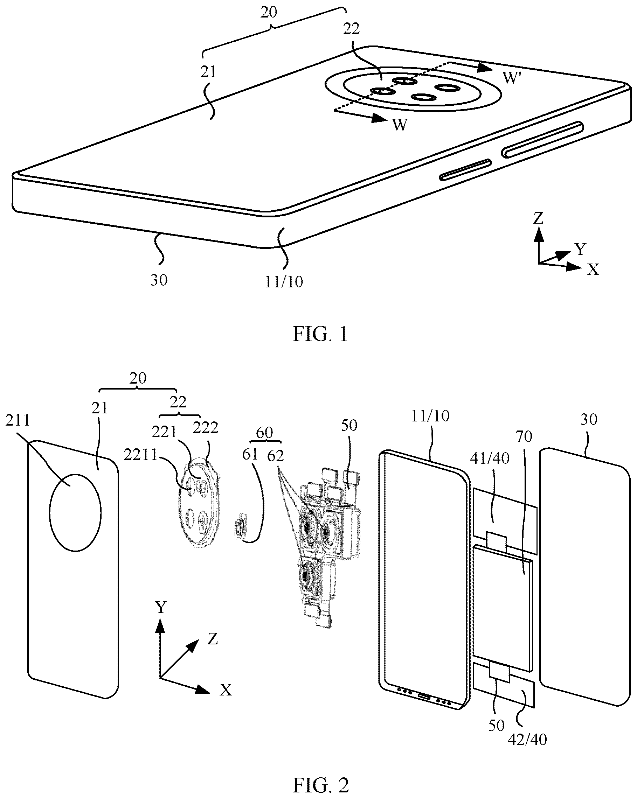

Refer to FIG. 1. FIG. 1 is a schematic diagram of a structure of an electronic device according to an embodiment of this application. As shown in FIG. 1, a mobile phone includes a middle frame 10, a housing assembly 20, and a display 30.

In FIG. 1, the mobile phone 100 is in a shape of a rectangular flat plate. To clearly describe subsequent structural features and a positional relationship between the structural features, a positional relationship between structures in the mobile phone is specified by using an X-axis direction, a Y-axis direction, and a Z-axis direction. The X-axis direction is a width direction of the mobile phone, the Y-axis direction (also referred to as a second direction) is a length direction of the mobile phone, and the Z-axis direction (also referred to as a first direction) is a thickness direction of the mobile phone. It can be understood that a coordinate system (that is, an X axis, a Y axis, and a Z axis) of the electronic device may be flexibly set based on an actual requirement, and is not specifically limited herein. In another optional embodiment, the electronic device may be in a shape of a square flat plate, a circular flat plate, an oval flat plate, or the like. Certainly, the electronic device may alternatively be a foldable electronic device or the like.

Refer to FIG. 2. FIG. 2 is an exploded view of an electronic device according to an embodiment of this application. As shown in FIG. 1 and FIG. 2, the middle frame 10 includes an exterior part 11 and a support member (not shown in the figure). The exterior part 11 of the middle frame 10, the housing assembly 20, and the display 30 may enclose an accommodating cavity, and the support member of the middle frame 10 is located between the display 30 and the housing assembly 20. Structures such as a printed circuit board (Printed Circuit Board, PCB) 40, a flexible printed circuit (flexible printed circuit, FPC) 50, a camera module 60, and a battery 70 are disposed in the accommodating cavity. The support member of the middle frame 10 may support some structures in the accommodating cavity and/or the display 30, for example, the display 30 is fastened to the support member by using a back adhesive.

In this embodiment of this application, the PCB 40 includes a main board 41 and a sub-board 42. The main board 41 and the sub-board 42 are respectively disposed on two sides of the battery 70 in the Y-axis direction, and the FPC 50 passes through the battery 70 (located on a side of the battery 70 in the Z-axis direction) and is electrically connected to the main board 41 and the sub-board 42, to implement data and signal transmission between the main board 41 and the sub-board 42.

Functional components such as a control chip are integrated on the main board 40. The control chip includes, for example, a system on chip (System on Chip, SoC), an application processor (Application Processor, AP), a radio frequency component, and a baseband component (not shown in the figure). The SoC is integrated with, for example, a central processing unit (Central Processing Unit, CPU), a graphics processing unit (Graphic Processing Unit, GPU), and a modem (Modem).

The sub-board 50 is integrated with functional components such as a universal serial bus (Universal Serial Bus, USB) component.

The functional components are all electronic components disposed on the PCB, for example, include a chip, a USB component, and the like that each have a control function, and include passive components such as a resistor, a capacitor, and an inductor.

The camera module 60 includes, for example, a rear-facing camera 61. There may be one or more rear-facing cameras 61. When there are a plurality of rear-facing cameras 61, functions of the plurality of rear-facing cameras 61 may be different. In a possible implementation, for example, there are three rear-facing cameras 61, one of the rear-facing cameras 61 is a primary camera, one of the rear-facing cameras 61 is responsible for zooming, and one of the rear-facing cameras 61 is responsible for panorama. In some embodiments, the camera module 60 further includes a flash 62. When a user uses a shooting function of the mobile phone for shooting in a dark environment, the flash 62 may fill light to improve a shooting effect.

The rear-facing camera 61 is electrically connected to the main board 41 by using an FPC 50. In some embodiments, a board to board (board to board, BTB) connector (not shown in the figure) is disposed between the FPC 50 of the rear-facing camera 61 and the main board 41, and the FPC 50 of the rear-facing camera 61 is electrically connected to the main board 41 by using the BTB. Similarly, the FPC 50 electrically connected to the main board 41 and the sub-board 42 may also be electrically connected to the main board 41 and the sub-board 42 by using BTBs. To be specific, one BTB may be disposed between the main board 41 and the FPC 50 (the FPC 50 electrically connected to the main board 41 and the sub-board 42), and the FPC 50 is electrically connected to the main board 41 by using the BTB; and another BTB may be disposed between the sub-board 42 and the FPC 50, and the same FPC 50 is electrically connected to the sub-board 42 by using the BTB, so that the main board 41 is electrically connected to the sub-board 42 by using the FPC 50.

The battery 70 is configured to supply power to the display 30, at least some functional components on the main board 41, at least some functional components on the sub-board 42, the camera module 60, and the like, to ensure normal operation thereof.

Continue to refer to FIG. 1 and FIG. 2. The housing assembly 20 includes a battery cover (also referred to as a rear cover or a rear housing) 21 and a decorative member 22, and a decorative hole 211 is disposed on the battery cover 21.

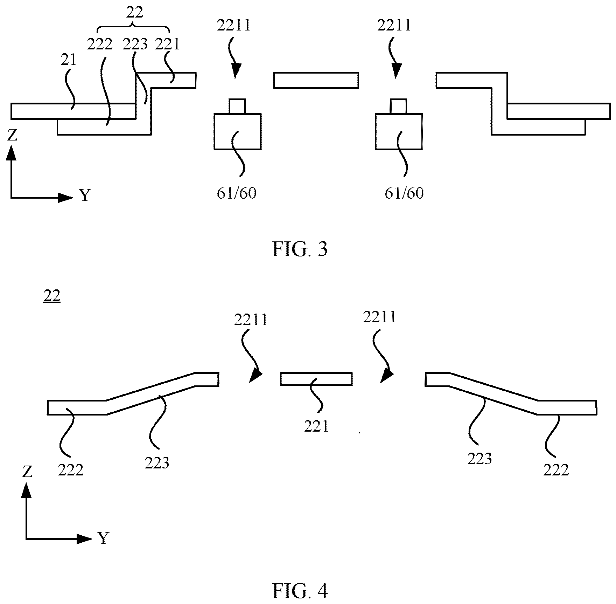

Refer to FIG. 3. FIG. 3 is a sectional view of the electronic device shown in FIG. 1 in a direction WW'. It should be noted that, to more clearly display a positional relationship between the battery cover 21, the decorative member 22, and the camera module 60, FIG. 3 shows only the battery cover 21, the decorative member 22, and the camera module 60, but does not show other structures such as the display 30. As shown in FIG. 2 and FIG. 3, the decorative member 22 includes a shielding part 221 and a skirt edge 222. The skirt edge 222 is disposed around the shielding part 221. A plane in which the shielding part 221 is located (that is, a plane formed by an X axis and a Y axis) is different from a plane in which the skirt edge 222 is located (that is, the plane formed by the X axis and the Y axis), that is, the shielding part 221 and the skirt edge 222 are respectively located in different planes. Correspondingly, the decorative member 22 further includes, for example, a connection part 223 connecting the shielding part 221 and the skirt edge 222. A light-transmitting hole 2211 is disposed on the shielding part 221.

The decorative member 22 is fastened to the battery cover 21 by using the skirt edge 222, the shielding part 221 of the decorative member 22 is exposed through the decorative hole 211 of the battery cover 21, and at least a part of the connection part 223 is located in the decorative hole 211. In the Z-axis direction, the rear-facing camera 61 is opposite to the shielding part 221, that is, a projection of the rear-facing camera 61 on the plane formed by the X axis and the Y axis overlaps with a projection of the shielding part 221 on the plane formed by the X axis and the Y axis, and the rear-facing camera 61 collects a light source through the light-transmitting hole 2211, to implement functions such as shooting and/or video recording.

It should be noted herein that, in FIG. 1-FIG. 3, an example in which the connection part 223 is separately perpendicular to the shielding part 221 and the skirt edge 222 is used for description, but does not constitute a limitation on this application. In another optional embodiment of this application, refer to FIG. 4. FIG. 4 is a schematic diagram of a structure of a decorative member according to an embodiment of this application. As shown in FIG. 4, the connection part 223 may alternatively be disposed in a tilted manner. For example, the connection part 223 is in a shape of a volcanic vent, and the shape of the so-called volcanic vent is a horn shape that is narrow at the top and wide at the bottom. Appearance quality of the electronic device may be improved by setting the volcanic vent shape.

A shape of the decorative hole 211 is not limited in this embodiment of this application. For example, the shape of the decorative hole 211 may include, for example, a racetrack shape, a circular shape, a rounded square shape, or a rounded rectangular shape. This embodiment of this application is described by using an example in which the shape of the decorative hole 211 is a circular shape. It can be understood that the racetrack shape may be a shape enclosed by two arcs and two opposite edges of a rectangular shape, where the two arcs are disposed opposite to each other, and the two arcs are separately adjacent to the two opposite edges.

It can be understood that a shape of the shielding part 221 corresponds to the shape of the decorative hole 211. For example, when the shape of the decorative hole 211 is a circular shape, the shape of the shielding part 221 is also a circular shape.

It can be learned from the background that as electronic devices such as a mobile phone and a tablet computer are increasingly enriched in functions and improved in performance, more components are required to be integrated on a PCB (that is, the main board and/or the sub-board). There is only one PCB in a conventional electronic device, and more components can be arranged only in a plane direction. However, as a battery life and capacity increase (that is, a battery size increases), a circuit board size correspondingly decreases. In addition, to meet a higher shooting requirement, more cameras are included in a camera module, and a size of the camera module becomes larger. In this case, a size of a hole in a central region of the main board for avoiding the camera module becomes larger, resulting in a decrease in an area of a projection of the main board on a plane formed by an X axis and a Y axis. Consequently, a layout area of the PCB is insufficient. In other words, an area of the PCB for disposing functional components is small, which cannot meet a requirement of integrating more components on the PCB.

Based on this, an embodiment of this application further provides an electronic device. The electronic device includes a housing structure and a circuit board assembly located on a side of the housing structure. When heights of different regions of the housing structure are different, quantities of surfaces (surfaces of circuit boards) in the circuit board assembly that correspond to different regions of the housing structure and that are each provided with a functional component are different, and quantities of surfaces in the circuit board assembly that correspond to different positions in a same region (at a same height) of the housing structure and that are each provided with a functional component may be the same or different. The circuit board assembly includes at least two circuit boards. In the Z-axis direction, each circuit board includes two surfaces facing away from each other. "Quantities of surfaces each provided with a functional component are different" may be that quantities of stacked circuit boards that are in the circuit board assembly and that correspond to different regions of the housing structure are different and the two surfaces of each circuit board are each provided with a functional component, may be that quantities of stacked circuit boards that are in the circuit board assembly and that correspond to different regions of the housing structure are the same but quantities of surfaces each provided with a functional component are different, may be that quantities of stacked circuit boards that are in the circuit board assembly and that correspond to different regions of the housing structure are different and quantities of surfaces each provided with a functional component are also different, or the like. In this way, a quantity of circuit boards is increased by using a space of the electronic device in the Z-axis direction, thereby increasing a component arrangement area, and improving component integration. In addition, different regions of the housing structure have different height limitations on the circuit board assembly. Correspondingly, the quantities of surfaces in the circuit board assembly that correspond to different regions and that are each provided with a functional component are different, so that the space of the electronic device in the Z-axis direction is fully used, thereby resolving a problem of an insufficient layout area. The housing structure may be, for example, the decorative member or the battery cover described above (for example, an electronic device whose battery cover has different heights in different regions, for example, a smartwatch). This is not limited in this embodiment of this application.

The following describes, with reference to specific examples, specific structures of the housing structure and the circuit board assembly that are provided in this embodiment of this application and a positional relationship between the structures. For more convenient and clear description of subsequent solutions, the following describes the specific structures of the housing structure and the circuit board assembly and the positional relationship between the structures by using an example in which the housing structure is a decorative member. The following content does not constitute a limitation on this application.

It can be understood that when the housing structure is a battery cover or the like, specific structures of the circuit board assembly that correspond to different regions of the battery cover and generated effects are the same as those in the following examples in which the housing structure is a decorative member. The specific structures of the circuit board assembly and a positional relationship between the structures when the housing structure is a battery cover are not described below again.

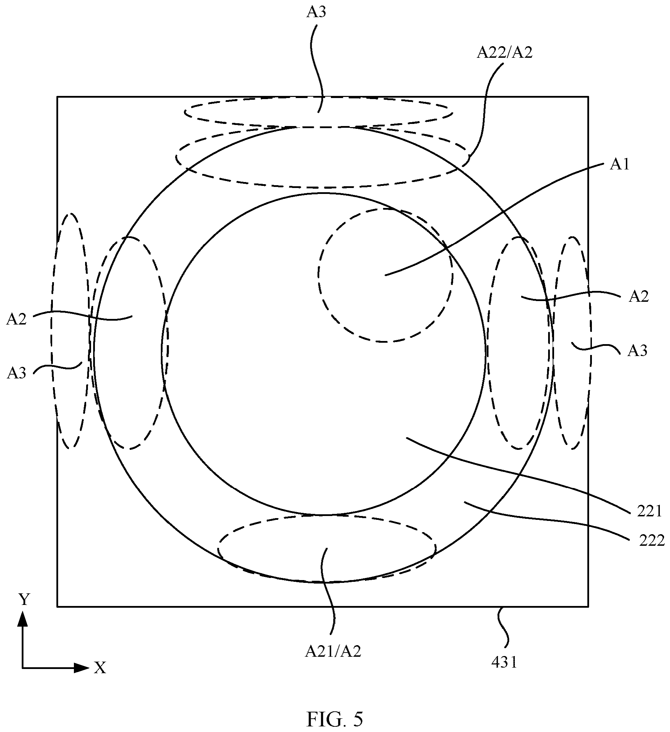

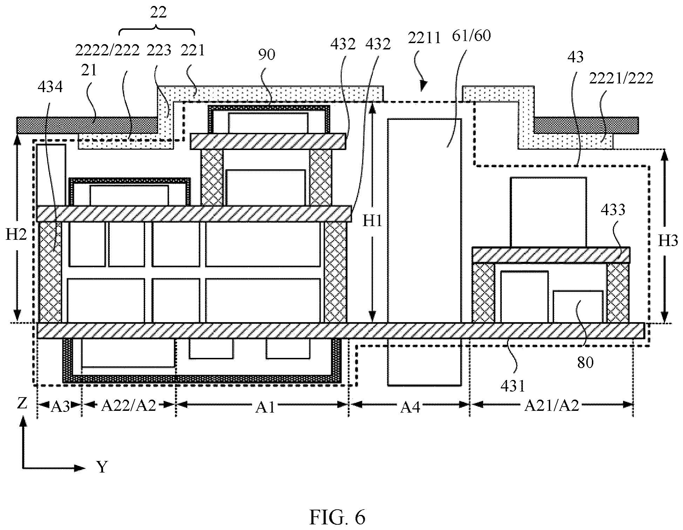

Refer to FIG. 5 and FIG. 6. FIG. 5 is a top view of a positional relationship between a decorative member and a circuit board assembly according to an embodiment of this application. FIG. 6 is a side view of a positional relationship between a decorative member, a circuit board assembly, and a battery cover according to an embodiment of this application. As shown in FIG. 5 and FIG. 6, the PCB 40 includes a circuit board assembly 43, that is, the main board 41 and/or the sub-board 42 in the foregoing content are or is the circuit board assembly 43. This embodiment of this application is described by using an example in which the main board 41 is the circuit board assembly 43. The circuit board assembly 43 includes a first circuit board 431, the first circuit board 431 includes at least two regions, and the at least two regions include a first region A1 and a second region A2. The circuit board assembly 43 further includes at least one second circuit board 432 stacked in the first region A1 and at least one third circuit board 433 stacked in the second region A2. In the Z-axis direction, two adjacent circuit boards are stacked at an interval. "Two adjacent circuit boards are stacked at an interval" means that, in the Z-axis direction, there is a specific distance between the two adjacent circuit boards and the two adjacent circuit boards are not in direct contact. The circuit board assembly 43 further includes a support connector 434. The support connector 434 is located between two adjacent circuit boards in the Z-axis direction, and is configured to support the circuit board and electrically connect the two adjacent circuit boards. The two adjacent circuit boards and the support connector 434 located between the two adjacent circuit boards enclose an accommodating space. In the Z-axis direction, each circuit board includes a first surface and a second surface that face away from each other, each of the first surface and/or the second surface of each circuit board is provided with a functional component 80, and a functional component 80 located between two adjacent circuit boards is disposed in the accommodating space. That is, in the Z-axis direction, each of the first circuit board 431, the second circuit board 432, and the third circuit board 433 includes a first surface and a second surface that face away from each other. Each of the first surface and/or the second surface of the first circuit board 431 is provided with a functional component 80, each of the first surface and/or the second surface of the second circuit board 432 is provided with a functional component 80, and each of the first surface and/or the second surface of the third circuit board 433 is provided with a functional component 80. A functional component 80 between the first circuit board 431 and one of the second circuit boards 432 is located in the accommodating space enclosed by the first circuit board 431, one of the second circuit boards 432, and the support connector 434 between the two circuit boards. A functional component 80 between two second circuit boards 432 is located in the accommodating space enclosed by the two second circuit boards 432 and the support connector 434 between the two second circuit boards 432. A functional component 80 between the first circuit board 431 and the third circuit board 433 is located in the accommodating space enclosed by the first circuit board 431, the third circuit board 433, and the support connector 434 between the two circuit boards.

It can be learned from the foregoing content that the decorative member includes the shielding part 221 (also referred to as a first part) and the skirt edge 222 (also referred to as a second part), and the shielding part 221 and the skirt edge 222 are located in different planes. Specifically, in the Z-axis direction, a distance from the plane in which the shielding part 221 is located to the first circuit board 431 is greater than a distance from the plane in which the skirt edge 222 is located to the first circuit board 431. The first region A1 is opposite to the shielding part 221, and the second region A2 is opposite to the skirt edge 222, that is, a projection of the shielding part 221 on the first circuit board 431 overlaps with the first region A1, and a projection of the skirt edge 222 on the first circuit board 431 overlaps with the second region A2. A quantity of surfaces each provided with a functional component in the first region A1 is greater than a quantity of surfaces each provided with a functional component in the second region A2. Because each circuit board includes only two surfaces, a quantity of surfaces each provided with a functional component is related to a quantity of circuit boards. When the quantity of surfaces each provided with a functional component in the first region A1 is greater than the quantity of surfaces each provided with a functional component in the second region A2, a quantity of second circuit boards 432 located in the first region A1 may be greater than a quantity of third circuit boards 433 located in the second region A2, or a quantity of second circuit boards 432 located in the first region A1 may be the same as a quantity of third circuit boards 433 located in the second region A2, but the first surface or the second surface of the third circuit board 433 located in the second region A2 is provided with no functional component, or the like. In this way, the first region A1 and the second region A2 of the circuit board assembly 43 can correspond to different parts of the decorative member (the first region A1 corresponds to the first part, and the second region A2 corresponds to the second part) because of having different heights in the Z-axis direction. Compared with disposing more functional components in the plane direction, this embodiment of this application can fully use the space of the electronic device in the Z-axis direction, thereby resolving the problem of an insufficient layout area.

That is, because the distance from the plane in which the shielding part 221 is located to the first circuit board 431 is greater than the distance from the plane in which the skirt edge 222 is located to the first circuit board 431, a space between the plane in which the shielding part 221 is located and the first circuit board 431 is larger, and a space between the plane in which the skirt edge 222 is located and the first circuit board 431 is smaller. More functional components 80 are disposed and/or a functional component 80 with a larger height is disposed in the region with the larger space, and fewer functional components 80 are disposed and/or a functional component 80 with a smaller height is disposed in the region with the smaller space, thereby fully using the space of the electronic device in the Z-axis direction, and resolving the problem of an insufficient layout area.

It should be noted that quantities of surfaces each provided with a functional component at different positions in a same region may be the same or different. The quantities may be specifically determined based on heights of functional components disposed at different positions. For example, the second region A2 includes a first sub-region A21 and a second sub-region A22. Two circuit boards are disposed in each of the first sub-region A21 and the second sub-region A22, and the first sub-region A21 is provided with a component with a larger height such as a BTB. Therefore, only three of four surfaces in the first sub-region A21 are each provided with a functional component, but four surfaces in the second sub-region A22 are each provided with a functional component.

For example, continue to refer to FIG. 5 and FIG. 6. The circuit board assembly 43 includes a first circuit board 431, and the first circuit board 431 includes a first region A1, a second region A2, and a third region A3. The first region A1 is opposite to the shielding part 221, that is, a projection of the shielding part 221 on a plane in which the first circuit board 431 is located overlaps with the first region A1. The second region A2 is opposite to the skirt edge 222, that is, a projection of the skirt edge 222 on the plane in which the first circuit board 431 is located overlaps with the second region A2. The third region A3 is opposite to a preset region of the battery cover 21, and the preset region of the battery cover 21 is a part in which a projection of the battery cover 21 on the plane in which the first circuit board 431 is located overlaps with the third region A3. The second region A2 includes a first sub-region A21 and a second sub-region A22. The first sub-region A21 and the second sub-region A22 correspond to different positions of the skirt edge 222. For example, the first sub-region A21 corresponds to a first position 2221 of the skirt edge 222, and the second sub-region A22 corresponds to a second position 2222 of the skirt edge 222. In the Y-axis direction, the first position 2221 and the second position 2222 are located on two opposite sides of the shielding part 221. The shielding part 221, the skirt edge 222, and the preset region of the battery cover 21 are located in different planes. Specifically, in the Z-axis direction, a distance H1 from the plane in which the shielding part 221 is located to the first circuit board 431 is greater than a distance H2 from a plane in which the preset region of the battery cover 21 is located to the first circuit board 431, and the distance H2 from the plane in which the preset region of the battery cover 21 is located to the first circuit board 431 is greater than a distance H3 from the plane in which the skirt edge 222 is located to the first circuit board 431.

The circuit board assembly 43 further includes two second circuit boards 432 stacked in the first region A1 and one third circuit board 433 stacked in the first sub-region A21 of the second region A2, and the second circuit board 432 that is in the two second circuit boards 432 disposed in the first region A1 and that is adjacent to the first circuit board 431 extends to the second sub-region A22 of the second region A2 and the third region A3. This is because a large part of region opposite to the shielding part 221 is configured to dispose the camera module 60, and the remaining region may be used for disposing a circuit board. A circuit board in a region adjacent to the remaining region (a region in which the second sub-region A22 is located), a circuit board in a region in which the third region A3 is located and that is adjacent to the region in which the second sub-region A22 is located, and the circuit board disposed in the remaining region may constitute one circuit board, thereby reducing a quantity of circuit boards, and further simplifying a process step. In this way, the first region A1 includes three circuit boards (one first circuit board 431 and two second circuit boards 432), the first sub-region A21 of the second region A2 includes two circuit boards (one first circuit board 431 and one third circuit board 433), the second sub-region A22 of the second region A2 includes two circuit boards (one first circuit board 431 and one second circuit board 432), the third region A3 includes two circuit boards (one first circuit board 431 and one second circuit board 432), and the second circuit board 432 in the second sub-region A22, the second circuit board 432 in the third region A3, and one of the second circuit boards 432 (the second circuit board 432 adjacent to the first circuit board 431) in the first region A1 constitute one circuit board.

In the Z-axis direction, the first circuit board 431 is stacked with the third circuit board 433 at an interval, and the first circuit board 431 and the two second circuit boards 432 are successively stacked at intervals, that is, the first circuit board 431 is stacked with one of the second circuit boards 432 (the second circuit board 432 adjacent to the first circuit board 431) at an interval, and one of the second circuit boards 432 (the second circuit board 432 adjacent to the first circuit board 431) is stacked with the other second circuit board 432 (the second circuit board 432 away from the first circuit board 431) at an interval.

The circuit board assembly 43 further includes a support connector 434. In the Z-axis direction, at least one support connector 434 (also referred to as a first support connector) is disposed between the first circuit board 431 and one of the second circuit boards 432, the at least one support connector 434 is disposed, for example, at a periphery of the second circuit board 432, and the support connector 434 is configured to support the second circuit board 432 and electrically connect the first circuit board 431 to the second circuit board 432; at least one support connector 434 (also referred to as a second support connector) is also disposed between one of the second circuit boards 432 (the second circuit board 432 adjacent to the first circuit board 431) and the other second circuit board 432 (the second circuit board 432 away from the first circuit board 431), the at least one support connector 434 is disposed, for example, at a periphery of the other second circuit board 432, and the support connector 434 is configured to support the other second circuit board 432 and electrically connect the two second circuit boards 432; and at least one support connector 434 (also referred to as a third support connector) is also disposed between the first circuit board 431 and the third circuit board 433, the at least one support connector 434 is disposed, for example, at a periphery of the third circuit board 433, and the support connector 434 is configured to support the third circuit board 433 and electrically connect the first circuit board 431 to the third circuit board 433. In the Z-axis direction, each circuit board includes a first surface and a second surface that face away from each other. The second surface is located on a side that is of the first surface and that faces away from the display 30. In other words, the first surface is located on a side that is of the second surface and that faces away from the battery cover 21. The second surface of the first circuit board 431, the first surface of the third circuit board 433, and the third support connector 434 between the first circuit board 431 and the third circuit board 433 enclose an accommodating space (also referred to as a third accommodating space), the second surface of the first circuit board 431, the first surface of one of the second circuit boards 432, and the first support connector 434 between the first circuit board 431 and the second circuit board 432 enclose another accommodating space (also referred to as a first accommodating space), and the second surface of one of the second circuit boards 432, the first surface of the other second circuit board 432, and the second support connector 434 between the two second circuit boards 432 enclose still another accommodating space (also referred to as a second accommodating space).

The first surface and the second surface of the first circuit board 431 are each provided with a functional component 80, the first surface and the second surface of one of the second circuit boards 432 (the second circuit board 432 adjacent to the first circuit board 431) are each provided with a functional component 80, only the second surface of the other second circuit board 432 is provided with a functional component 80, and only the second surface of the third circuit board 433 is provided with a functional component 80. In addition, a height of a highest functional component 80 in the first sub-region A21 of the second region A2 is less than a height of a highest functional component 80 in the first region A1, thereby reducing a thickness of the support connector 434 between the first circuit board 431 and the third circuit board 433, and ensuring a minimum overall thickness of the circuit board assembly 43 in the first sub-region A21. In addition, functional components 80 on the second surface of the first circuit board 431 that correspond to the first region A1, the second sub-region A22, and the third region A3 and a functional component 80 on the first surface of the second circuit board 432 are all located in the first accommodating space, a functional component 80 that is on the second surface of the second circuit board 432 adjacent to the first circuit board 431 and that corresponds to the first region A1 is located in the second accommodating space, and a functional component 80 that is on the second surface of the first circuit board 431 and that corresponds to the first sub-region is located in the third accommodating space, thereby protecting the functional components 80. In addition, a shielding cover 90 may be disposed on an outer side of a functional component 80 that is not disposed in the accommodating space to protect the functional component 80, for example, a shielding cover 90 is disposed on an outer side of a functional component 80 on the first surface of the first circuit board 431, and shielding covers 90 are disposed on outer sides of functional components 80 on the second surfaces of the second circuit boards 432.

That is, distances from the shielding part 221 of the decorative member 22, the skirt edge 222 of the decorative member 22, and the preset region of the battery cover 21 to the first circuit board 41 are different, that is, the shielding part 221 of the decorative member 22, the skirt edge 222 of the decorative member 22, and the preset region of the battery cover 21 have different height limitations on the circuit board assembly 43. Based on height limitation differences, five surfaces in the first region A1 (the two surfaces of the first circuit board 431, the two surfaces of one of the second circuit boards 432, and the second surface of the other second circuit board 432) are each provided with a functional component 80, and four surfaces in the second sub-region A22 of the second region A2 and the third region A3 (the two surfaces of the first circuit board 431 and the two surfaces of one of the second circuit boards 432) are each provided with a functional component 80. In addition, because the preset region that is of the battery cover 21 and that corresponds to the third region A3 has a larger height, a functional component 80 on one of surfaces in the third region A3 has a larger height, for example, a functional component 80 at a position that is of the second surface of the second circuit board 432 and that corresponds to the third region A3. In this way, a thickness of the support connector 434 between the first circuit board 431 and the second circuit board 432 can be reduced. Three surfaces in the first sub-region A21 of the second region A2 are each provided with a functional component, so that one of surfaces in the first sub-region A21 of the second region A2 can be provided with a functional component with a larger height, for example, the second surface of the third circuit board 433 is provided with a BTB with a larger thickness, for example, the BTB connecting the FPC 50 to the main board 41 in the foregoing content. Therefore, the space of the entire electronic device in the Z-axis direction is fully used, and the problem of an insufficient layout area is resolved.

It can be understood that the thickness of the support connector 434 may be determined based on heights of and a gap (a gap between functional components on two opposite surfaces of two circuit boards in the Z-axis direction) between functional components that are actually laid.

A type of the support connector 434 is not limited in this embodiment of this application, provided that a circuit board can be supported and two adjacent circuit boards can be electrically connected.

In a possible implementation, continue to refer to FIG. 6. The support connector 434 includes a frame board (frame board, FB), and the FB is a PCB board that is hollowed in the middle or locally hollowed.

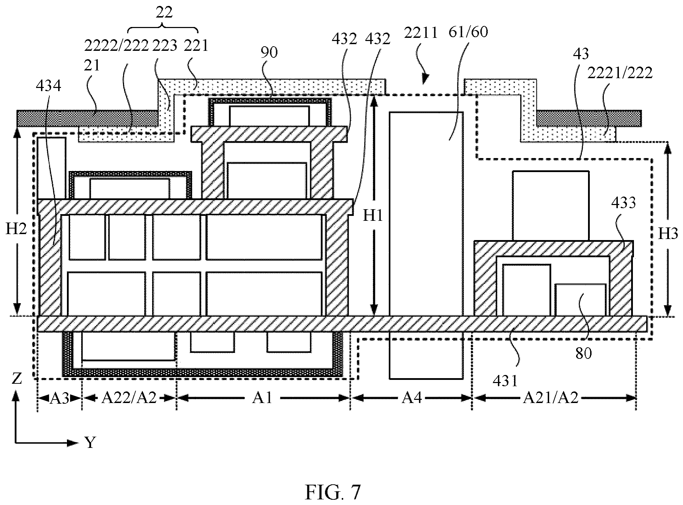

In another possible implementation, refer to FIG. 7. FIG. 7 is a side view of another positional relationship between a decorative member, a circuit board assembly, and a battery cover according to an embodiment of this application. As shown in FIG. 7, the support connector 434 is integrally formed with a circuit board, that is, the first support connector is integrally formed with one of the second circuit boards 432, the second support connector is integrally formed with the other second circuit board 432, and the third support connector is integrally formed with the third circuit board 433. For example, the first support connector and one of the second circuit boards 432 that are integrally formed, the second support connector and the other second circuit board 432 that are integrally formed, and the third support connector and the third circuit board 433 that are integrally formed are formed through a manufacturing process of a cavity (local recession) structure of a Pcb.

When the main board in the mobile phone is the circuit board assembly 43, because the circuit board assembly 43 and the camera module 60 are disposed in a region opposite to the shielding part 221 of the decorative member 22, to avoid interference between the circuit board assembly 43 and the camera module 60, the circuit board assembly 43 may be correspondingly improved based on a thickness of the camera module 60 (a size in the Z-axis direction).

In a possible implementation, the camera module 60 is thick, for example, the thickness of the camera module 60 is greater than a distance from the shielding part 221 to the first circuit board 431. To avoid the camera module 60, continue to refer to FIG. 6. The first circuit board 431 further includes a fourth region A4, and the fourth region A4 is opposite to the shielding part 221, that is, the projection of the shielding part 221 on the first circuit board 431 overlaps with the fourth region A4. To avoid a camera, the first circuit board 431 is provided with an avoidance hole in the fourth region A4. One end of the camera module 60 passes through the avoidance hole and is fixedly connected to the support member of the middle frame 10, to support the camera module 60 by using the support member.

A size of the avoidance hole is not limited in this embodiment of this application. A person skilled in the art may set the size according to an actual situation, provided that the camera module 60 can be prevented from being interfered with and shielded, and normal operation of the camera module 60 can be ensured.

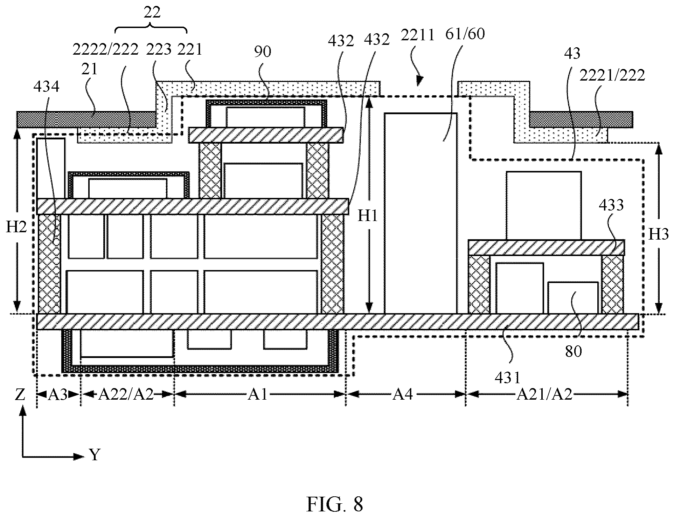

In another possible implementation, the thickness of the camera module 60 is moderate. For example, a difference between the distance from the shielding part 221 to the first circuit board 431 and the thickness of the camera module 60 is within a preset range. The preset range is, for example, 0.5 mm-3.5 mm. For example, the difference between the distance from the shielding part 221 to the first circuit board 431 and the thickness of the camera module 60 is 0.5 mm, 1 mm, 1.5 mm, 2 mm, 2.5 mm, 3 mm, 3.5 mm, or the like. Refer to FIG. 8. FIG. 8 is a side view of still another positional relationship between a decorative member, a circuit board assembly, and a battery cover according to an embodiment of this application. As shown in FIG. 8, the first circuit board 431 further includes a fourth region A4. The fourth region A4 is opposite to the shielding part 221, that is, the projection of the shielding part 221 on the first circuit board 431 overlaps with the fourth region A4, and the camera module 60 is disposed in the fourth region A4 of the first circuit board 431, to fasten and support the camera module 60 by using the first circuit board 431. In this way, a position for disposing the camera module 60 is more flexible, and a region of the support member of the middle frame 10 may be released, thereby facilitating disposing another structure on the support member.

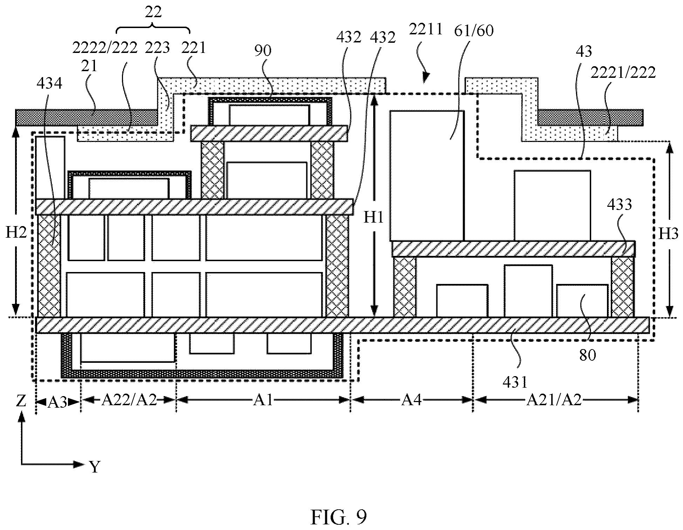

In still another possible implementation, the camera module 60 is thin. For example, a difference between the distance from the shielding part 221 to the third circuit board 433 and the thickness of the camera module 60 is within a preset range. The preset range is, for example, 0.5 mm-3.5 mm. For example, the difference between the distance from the shielding part 221 to the third circuit board 433 and the thickness of the camera module 60 is 0.5 mm, 1 mm, 1.5 mm, 2 mm, 2.5 mm, 3 mm, 3.5 mm, or the like. Refer to FIG. 9. FIG. 9 is a side view of still another positional relationship between a decorative member, a circuit board assembly, and a battery cover according to an embodiment of this application. As shown in FIG. 9, the third circuit board 433 extends to be below the camera module 60, and the camera module 60 is disposed on the third circuit board 433, that is, in addition to a functional component such as a BTB, the camera module 60 is also disposed on the second surface of the third circuit board 433, to fasten and support the camera module 60 by using the third circuit board 433. In this way, a position for disposing the camera module 60 is more flexible, and a region of the support member of the middle frame 10 may be released, thereby facilitating disposing another structure on the support member.

In conclusion, in the electronic device provided in this embodiment of this application, because the distances from the shielding part 221 of the decorative member 22, the skirt edge 222 of the decorative member 22, and the preset region of the battery cover 21 to the first circuit board 41 are different, that is, because different positions of the decorative member 22 have different height limitations on the circuit board assembly 43, the height limitation differences are flexibly used to increase a quantity of circuit boards in the space in the Z-axis direction. In addition, the quantities of surfaces each provided with a functional component at different positions are different, so that the space of the electronic device in the Z-axis direction is fully used, thereby increasing a component arrangement area, improving component integration, and resolving the problem of an insufficient layout area.

An embodiment of this application further provides a method for preparing a circuit board assembly, which is used to prepare the circuit board assembly shown in FIG. 6 and has the same beneficial effects. For details not described in detail in the following content, refer to the foregoing content description. The following describes the method for preparing a circuit board assembly with reference to the circuit board assembly in FIG. 6, and the following content does not constitute a limitation on this application.

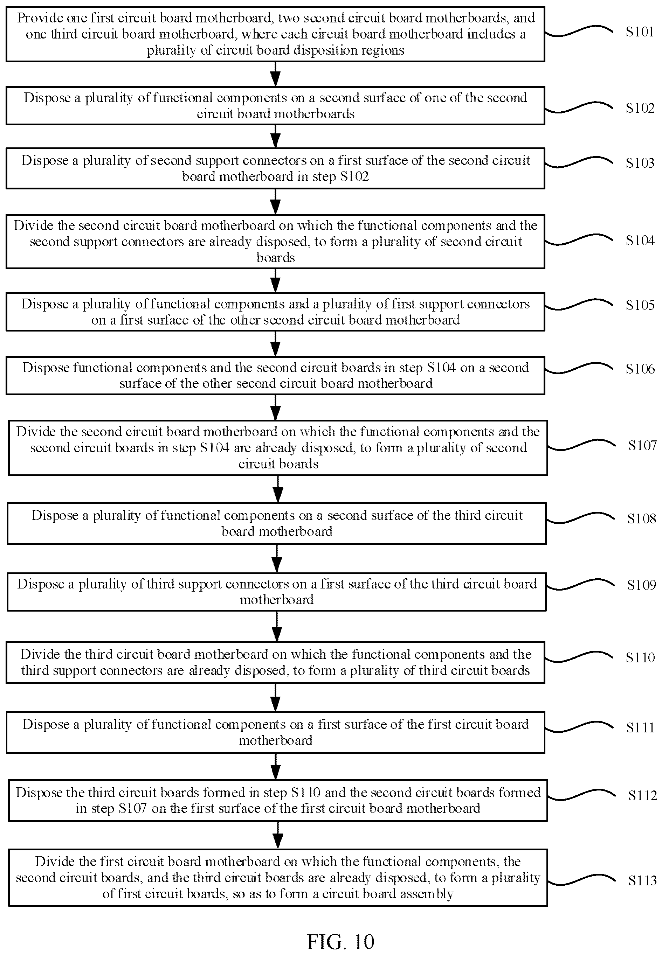

Refer to FIG. 10. FIG. 10 is a flowchart of a method for preparing a circuit board assembly according to an embodiment of this application. As shown in FIG. 10, the method for preparing a circuit board assembly includes the following steps.

S101: Provide one first circuit board motherboard, two second circuit board motherboards, and one third circuit board motherboard, where each circuit board motherboard includes a plurality of circuit board disposition regions.

To simplify a process step, a circuit board motherboard of a larger size may be provided first. The circuit board motherboard is divided after components are disposed in the circuit board disposition regions of the circuit board motherboard, where the motherboard is divided based on a quantity of circuit board disposition regions to form a plurality of circuit boards, that is, one circuit board disposition region corresponds to one circuit board.

S102: Dispose a plurality of functional components on a second surface of one of the second circuit board motherboards, where quantities and types of functional components in each circuit board disposition region of the second circuit board motherboard are the same.

S103: Dispose a plurality of second support connectors on a first surface of the second circuit board motherboard in step S102, where quantities of second support connectors in each circuit board disposition region of the second circuit board motherboard are the same.

It can be understood that the second support connectors need to be formed first before being disposed on the first surface of the second circuit board motherboard. For example, a second support connector motherboard is divided first to form the plurality of second support connectors. For specific steps of forming the second support connectors, refer to the conventional technology. Details are not described in this embodiment of this application.

S104: Divide the second circuit board motherboard on which the functional components and the second support connectors are already disposed, to form a plurality of second circuit boards, where a second surface of the second circuit board is provided with a functional component, and a first surface is provided with at least one second support connector.

The second circuit board 432 facing away from the first circuit board 431 in the foregoing content is formed through step S104.

S105: Dispose a plurality of functional components and a plurality of first support connectors on a first surface of the other second circuit board motherboard, where quantities and types of functional components in each circuit board disposition region of the second circuit board motherboard are the same, and quantities of first support connectors in each circuit board disposition region are the same.

It can be understood that the first support connectors need to be formed first before being disposed on the first surface of the second circuit board motherboard. For example, a first support connector motherboard is divided first to form the plurality of first support connectors. For specific steps of forming the first support connectors, refer to the conventional technology. Details are not described in this embodiment of this application.

S106: Dispose functional components and the second circuit boards in step S104 on a second surface of the other second circuit board motherboard, where quantities and types of functional components in each circuit board disposition region of the second circuit board motherboard are the same, and each circuit board disposition region of the second circuit board motherboard corresponds to one second circuit board in step S104.

S107: Divide the second circuit board motherboard on which the functional components and the second circuit boards in step S104 are already disposed, to form a plurality of second circuit boards, where a first surface of the second circuit board is provided with a functional component and at least one first support connector, and a second surface of the second circuit board is provided with a functional component and one second circuit board in step S104.

The second circuit board 432 adjacent to the first circuit board 431 in the foregoing content is formed through step S107, and the second circuit board 432 facing away from the first circuit board 431 is disposed on the second circuit board 432.

S108: Dispose a plurality of functional components on a second surface of the third circuit board motherboard, where quantities and types of functional components in each circuit board disposition region of the third circuit board motherboard are the same.

S109: Dispose a plurality of third support connectors on a first surface of the third circuit board motherboard, where quantities of third support connectors in each circuit board disposition region of the third circuit board motherboard are the same.

It can be understood that the third support connectors need to be formed first before being disposed on the first surface of the third circuit board motherboard. For example, a third support connector motherboard is divided first to form the plurality of third support connectors. For specific steps of forming the third support connectors, refer to the conventional technology. Details are not described in this embodiment of this application.

S110: Divide the third circuit board motherboard on which the functional components and the third support connectors are already disposed, to form a plurality of third circuit boards, where a second surface of the third circuit board is provided with a functional component, and a first surface is provided with at least one third support connector.

The third circuit board 433 in the foregoing content is formed through step S110.

S111: Dispose a plurality of functional components on a first surface of the first circuit board motherboard, where quantities and types of functional components in each circuit board disposition region of the first circuit board motherboard are the same.

S112: Dispose the third circuit boards formed in step S110 and the second circuit boards formed in step S107 on the first surface of the first circuit board motherboard, where quantities and types of functional components in each circuit board disposition region of the first circuit board motherboard are the same, and each circuit board disposition region of the first circuit board motherboard corresponds to one third circuit board in step S110 and one second circuit board in step S107.

S113: Divide the first circuit board motherboard on which the functional components, the second circuit boards, and the third circuit boards are already disposed, to form a plurality of first circuit boards, where a first surface of the first circuit board is provided with a functional component, and a second surface is provided with one third circuit board in step S110 and one second circuit board in step S107.

The first circuit board 431 in the foregoing content is formed through step S113, and two second circuit boards and one third circuit board are disposed on the first circuit board 431, that is, the circuit board assembly 43 in the foregoing content is formed.

It can be understood that, when the circuit board assembly further includes another structure, for example, a shielding cover, steps of preparing the circuit board assembly may be adaptively adjusted.

It should be noted that the foregoing example shows only a procedure of the method for preparing a circuit board assembly, but does not constitute a limitation on this application. For example, a plurality of functional components may alternatively be disposed on the first surface of the first circuit board motherboard first, and then a plurality of functional components are disposed on the second surface of one of the second circuit board motherboards.

The foregoing steps may be formed, for example, by using a reflow soldering process. The functional component on the second surface that is of the second circuit board 432 and that faces away from the first circuit board 431 needs to withstand a plurality of times of reflow, for example, withstand at least two times of low-temperature reflow (a low-temperature reflow soldering process is used for soldering the support connector) and two times of high-temperature flow (a high-temperature reflow soldering process is used for soldering the functional component), that is, the functional components on the circuit boards are not affected even if reflow soldering is performed a plurality of times.

In addition, the support connector 434 is integrally formed with a circuit board, that is, the first support connector is integrally formed with one of the second circuit boards 432, the second support connector is integrally formed with the other second circuit board 432, and the third support connector is integrally formed with the third circuit board 433. For example, the first support connector and one of the second circuit boards 432 that are integrally formed, the second support connector and the other second circuit board 432 that are integrally formed, and the third support connector and the third circuit board 433 that are integrally formed are formed through a manufacturing process of a cavity (local recession) structure of a Pcb, thereby further reducing a quantity of times of reflow, for example, only two times of high-temperature reflow are required (the high-temperature reflow soldering process is used for soldering the functional component). Specific process steps are similar to the foregoing process steps, a difference lies in that the step of disposing the support connector is not included. For details, refer to the foregoing steps, details are not described herein again.

The foregoing embodiments are merely intended to describe the technical solutions in this application, but not intended to limit the technical solutions in this application. Although this application is described in detail with reference to the foregoing embodiments, a person of ordinary skill in the art should understand that modifications may still be made to the technical solutions described in the foregoing embodiments or equivalent replacements may still be made to some technical features thereof. However, these modifications or replacements do not make the essence of the corresponding technical solutions depart from the scope of the technical solutions in the embodiments of this application.

## Claims

1. An electronic device, comprising:
a housing structure, comprising at least a first part and a second part, wherein a plane in which the first part is located is different from a plane in which the second part is located; and
a circuit board assembly, wherein in a first direction, the circuit board assembly is located on a side of the housing structure, and the first direction is perpendicular to the plane in which the first part is located, wherein
the circuit board assembly comprises at least two circuit boards, the at least two circuit boards comprise at least a first circuit board and at least one second circuit board that are stacked, and in the first direction, the first circuit board is located on a side that is of the second circuit board and that faces away from the housing structure, and a distance from the first part to the first circuit board is greater than a distance from the second part to the first circuit board; in the first direction, the circuit board comprises two surfaces facing away from each other, the two surfaces comprise a first surface and a second surface, and each of the first surface and/or the second surface is provided with a functional component;
a position that is of the circuit board assembly and that corresponds to the first part is provided with a functional component, and a quantity of surfaces each provided with a functional component is a first preset value; and
a position that is of the circuit board assembly and that corresponds to the second part is provided with a functional component, a quantity of surfaces each provided with a functional component is a second preset value, and the first preset value is greater than the second preset value.

2. The electronic device according to claim 1, wherein a quantity of circuit boards at the position that is of the circuit board assembly and that corresponds to the first part is a third preset value, a quantity of circuit boards at the position that is of the circuit board assembly and that corresponds to the second part is a fourth preset value, and the third preset value is greater than or equal to the fourth preset value.

3. The electronic device according to claim 1 or 2, wherein the circuit board assembly further comprises at least one third circuit board, the first circuit board comprises at least a first region and a second region, the second circuit board is located at least in the first region, the first circuit board is successively stacked with the at least one second circuit board at an interval, the third circuit board is located at least in the second region, and the first circuit board is successively stacked with the at least one third circuit board at an interval;
the circuit board assembly further comprises a support connector, located between two adjacent circuit boards, and configured to support the circuit board and electrically connect the two adjacent circuit boards; and
the first region is opposite to the first part, the second region is opposite to the second part, the first region is provided with a functional component, a quantity of surfaces each provided with a functional component is the first preset value, the second region is provided with a functional component, and a quantity of surfaces each provided with a functional component is the second preset value.

4. The electronic device according to any one of claims 1-3, wherein the electronic device further comprises a rear cover, and the housing structure is the rear cover of the electronic device.

5. The electronic device according to any one of claims 1-3, wherein the electronic device further comprises a rear cover, and a decorative hole is disposed on the rear cover;
the housing structure is a camera decorative member, the camera decorative member comprises a shielding part and a skirt edge, the skirt edge surrounds at least a part of the shielding part, the decorative member is fastened to the rear cover by using the skirt edge, and the shielding part is exposed through the decorative hole;
the first part is the shielding part, the second part is the skirt edge, H1>H2>H3, H1 is a distance from the shielding part to the first circuit board, H2 is a distance from the rear cover to the first circuit board, and H3 is a distance from the skirt edge to the first circuit board;
the first circuit board comprises a first region, a second region, and a third region, the first region is opposite to the shielding part, the second region is opposite to the skirt edge, the third region is opposite to a preset region of the rear cover, and the preset region of the rear cover is a part in which a projection of the rear cover on a plane in which the first circuit board is located overlaps with the third region; and
a quantity of surfaces each provided with a functional component in the first region is greater than a quantity of surfaces each provided with a functional component in the second region, and is greater than a quantity of surfaces each provided with a functional component in the third region.

6. The electronic device according to claim 5, wherein in a second direction, the second region comprises a first sub-region and a second sub-region disposed on two sides of the first region, and the second direction is perpendicular to the first direction;
the circuit board assembly comprises a first circuit board, two second circuit boards, and one third circuit board, the two second circuit boards are stacked at an interval in the first region, a second circuit board adjacent to the first circuit board extends to the second sub-region and the third region, and the third circuit board is disposed at least in the second sub-region;
the first surface is located on a side that is of the second surface and that faces away from the housing structure; and
two surfaces of the first circuit board are each provided with a functional component, two surfaces of the second circuit board adjacent to the first circuit board are each provided with a functional component, a second surface of the second circuit board away from the first circuit board is provided with a functional component, and a second surface of the third circuit board is provided with a functional component.

7. The electronic device according to claim 6, wherein in the first direction, a height of a first functional component is less than a height of a second functional component, the first functional component is a highest functional component disposed on a second surface of the first circuit board in the first sub-region, and the second functional component is a highest functional component disposed on the second surface of the first circuit board in another region.

8. The electronic device according to claim 6, wherein in the first direction, a height of the functional component on the second surface of the third circuit board is greater than a height of a functional component on a surface of another circuit board.

9. The electronic device according to claim 8, wherein the functional component on the second surface of the third circuit board comprises a board-to-board connector.

10. The electronic device according to claim 6, wherein a second surface of the first circuit board, a first surface of the second circuit board adjacent to the first circuit board, and the support connector enclose a first accommodating space, a second surface of the second circuit board adjacent to the first circuit board, a first surface of the second circuit board away from the first circuit board, and the support connector enclose a second accommodating space, and the second surface of the first circuit board, a first surface of the third circuit board, and the support connector enclose a third accommodating space; and
functional components on the second surface of the first circuit board that correspond to the first region, the second sub-region, and the third region and a functional component on the first surface of the second circuit board adjacent to the first circuit board are all located in the first accommodating space, a functional component that is on the second surface of the second circuit board adjacent to the first circuit board and that corresponds to the first region is located in the second accommodating space, and a functional component that is on the second surface of the first circuit board and that corresponds to the first sub-region is located in the third accommodating space.

11. The electronic device according to claim 6, wherein shielding covers are disposed on outer sides of at least some of the following functional components: a functional component on a first surface of the first circuit board, a functional component on a second surface of the second circuit board away from the first circuit board, and a functional component that is on a second surface of the second circuit board adjacent to the first circuit board and that corresponds to the second sub-region.

12. The electronic device according to any one of claims 5-11, wherein a light-transmitting hole is disposed on the shielding part, the electronic device further comprises a camera module, a projection of the camera module on the plane in which the first part is located overlaps with a projection of the shielding part on the plane in which the first part is located, and the camera module collects a light source through the light-transmitting hole.

13. The electronic device according to claim 12, wherein a thickness of the camera module is greater than the distance from the shielding part to the first circuit board; and
the first circuit board further comprises a fourth region, the fourth region is opposite to the shielding part, the first circuit board is provided with an avoidance hole in the fourth region, and one end of the camera module passes through the avoidance hole.

14. The electronic device according to claim 12, wherein a difference between the distance from the shielding part to the first circuit board and the thickness of the camera module is within a preset range; and
the first circuit board further comprises a fourth region, the fourth region is opposite to the shielding part, and the camera module is disposed in the fourth region of the first circuit board, to fasten and support the camera module by using the first circuit board.

15. The electronic device according to claim 12, wherein a difference between a distance from the shielding part to the third circuit board and the thickness of the camera module is within a preset range; and
the third circuit board extends to be below the camera module, and the camera module is disposed on the third circuit board, to fasten and support the camera module by using the third circuit board.

16. The electronic device according to any one of claims 3-15, wherein when the circuit board assembly further comprises the support connector, the support connector comprises a frame board.

17. The electronic device according to any one of claims 3-15, wherein when the circuit board assembly further comprises the support connector, the support connector is integrally formed with the circuit board.
